# EUROPEAN PATENT APPLICATION

(11) **EP 4 593 058 A1**
(43) Date of publication of application: **30.07.2025**
(21) Application number: 23867119.2
(22) Date of filing: 26.07.2023
(51) Int. Cl.: H01J 37/32

(54) **SUBSTRATE PROCESSING APPARATUS**

(30) Priority: 23.09.2022 CN 202211164031
(71) Applicant: ACM Research (Shanghai), Inc., Shanghai 201203 (CN); ACM Research Korea Co., Ltd., Icheon-si, Gyeonggi-do (KR); Cleanchip Technologies Limited, Hong Kong (HK)
(72) Inventor: WANG, Hui, Shanghai 201203 (CN); ZHANG, Shan, Shanghai 201203 (CN); LV, Ce, Shanghai 201203 (CN); XIE, Sulan, Shanghai 201203 (CN); FEI, Hongcai, Shanghai 201203 (CN); KIM, Tom, Icheon-si Gyeonggi-do (KR); LEE, Jacob, Icheon-si Gyeonggi-do (KR); BAEK, William, Icheon-si Gyeonggi-do (KR)
(74) Representative: Osha BWB
(86) International application number: PCT/CN2023/109215
(87) International publication number: WO 2024/060824

(57) **Abstract**

A substrate processing apparatus comprises a processing chamber and a gas supply portion configured in an upper portion of the processing chamber, for supplying the processing gas into the processing chamber. A plurality of substrate holding portions are configured in the processing chamber and located below the gas supply portion, for holding substrates. An exhaust portion is configured in a lower portion of the processing chamber, for exhausting gas from the processing chamber. The exhaust portion comprises a plurality of exhaust grooves, a plurality of exhaust flow channels and a shared main exhaust port. Each exhaust groove is configured with a substrate holding portion and two exhaust flow channels, to connect the exhaust groove to the main exhaust port. Wherein, the main exhaust port is located at a geometric center of a plurality of substrate holding portions, and the plurality of exhaust flow channels have the same exhaust volume.

## Description

### FIELD OF THE INVENTION

The present invention relates to the field of semiconductor equipment, and more particularly to a substrate processing apparatus with a uniform exhaust function.

### BACKGROUND

In the semiconductor manufacturing process, in order to simultaneously take into accounts the production efficiency and the precise control of the processing of a single substrate, a number of processing units (e.g., the processing units can be used to perform a process of thin film deposition and an etching process, etc., on a horizontally placed substrate) for the execution of the processing of a single substrate are usually integrated into the same processing chamber to form a substrate processing apparatus. In such a substrate processing apparatus, the nonuniformity of gas exhaust in the processing chamber usually results in a decrease in the uniformity of the distribution of the processing gas on the surface of the substrate, leading to a deterioration of the in-surface uniformity of a single substrate (e.g., a decrease in the levelness of the film formation on the surface of the substrate or a deterioration in the uniformity of the film etching) as well as difficulties in ensuring the consistency of the inter-slice between a number of substrates, causing adverse effects on the quality and reliability of the products.

### SUMMARY

In view of the above-described drawbacks of the prior art, the present invention aims to provide a substrate processing apparatus having a structure of the uniformity of gas exhaust, for solving problems in the prior art of poor uniformity of the in-surface of substrates and terrible consistency of the inter-slice between substrates in the processing chamber caused by the nonuniformity of gas exhaust.

To realize the above aim and other related aims, the present invention provides a substrate processing apparatus, comprising:
a processing chamber;
a gas supply portion, configured in an upper portion of the processing chamber, for supplying processing gas into the processing chamber;
a plurality of substrate holding portions, configured in the processing chamber and located below the gas supply portion, for holding substrates;
an exhaust portion, configured in a lower portion of the processing chamber, for exhausting gas from the processing chamber, the exhaust portion comprising a plurality of exhaust grooves, a plurality of exhaust flow channels and a shared main exhaust port, each exhaust groove configured with a substrate holding portion and two exhaust flow channels, for connecting the exhaust groove to the main exhaust port;
wherein, the main exhaust port is located at a geometric center of the plurality of substrate holding portions, and the plurality of exhaust flow channels have the same exhaust volume.

As an optional embodiment, two exhaust flow channels configured for each exhaust groove are symmetrical about a line connecting the center of exhaust groove and the center of main exhaust port, each exhaust groove and the two exhaust flow channels configured for each exhaust groove form an exhaust unit, and a plurality of exhaust units are uniformly distributed around a circumference centered on the main exhaust port.

As an optional embodiment, the plurality of exhaust flow channels are independent of each other.

As an optional embodiment, adjacent exhaust flow channels of different exhaust grooves at least partially overlap, so that the gas in the different exhaust grooves converge to flow all the way to the main exhaust port.

As an optional embodiment, each substrate holding portion comprises:
a carrier table, for holding the substrate;
a support shaft, the upper end of the support shaft being secured to the carrier table;
a liftable mechanism, connected to the lower end of the support shaft, for driving the carrier table up and down between a process position for performing a process treatment on the substrate and a transfer position for handing over the substrate to an external transfer mechanism.

As an optional embodiment, the substrate processing apparatus further comprises rectifier boards, with one of the rectifier boards fixed at an interval below each carrier table, when the carrier table is located in the process position, the rectifier board rises with the carrier table to the groove opening position of the corresponding exhaust groove, and an inlet annular gap is formed between the outer peripheral surface of the rectifier board and the inner peripheral surface of the exhaust groove.

As an optional embodiment, the rectifier boards are provided with a plurality of gas inlet holes.

As an optional embodiment, the gas supply portion comprises a plurality of gas nozzles corresponding to the plurality of exhaust grooves, each gas nozzle is disposed opposite to one carrier table for supplying the processing gas to a substrate holding on the carrier table, each gas nozzle has a deflector shield on the outer peripheral side, so that when the carrier table is in a process position, an exhaust annular gap is formed between the inner peripheral surface of the deflector shield and the outer peripheral surface of the carrier table, to allow the processing gas supplied by the gas nozzles to be discharged downwardly along the exhaust annular gap towards the corresponding exhaust grooves.

As described above, the present invention provides a substrate processing apparatus having the following beneficial effects:
(1) By configuring a plurality of exhaust grooves below the gas supply portion, when a process treatment is performed on the substrate, the exhaust grooves form a buffer space below the substrate for gas flow, which can avoid or mitigate gas disturbances;
(2) A main exhaust port is located at the geometric center of a plurality of substrate holding portions, and each exhaust groove is connected to the main exhaust port through two exhaust flow channels with the same exhaust volume, which is conducive to further smoothing and buffering the gas flow. Hence, the suction force functioned by the exhaust grooves in the entire circumferential direction of the substrate is basically the same, thereby realizing the uniformity of gas exhaust, and improving the thin film deposition of the substrate as well as the in-surface consistency of etching;
(3) By setting each exhaust flow channel with the same exhaust volume for a plurality of exhaust grooves, achieving the uniformity of gas exhaust for multiple substrates and a good inter-slice consistency.

### BRIEF DESCRIPTION OF THE DRAWINGS

FIG. 1 shows a schematic diagram of a longitudinal section of a substrate processing apparatus provided in embodiment 1 of the present invention, wherein a carrier table is located in a transfer position for handing over the substrate to an external transfer mechanism;
FIG. 2 shows a schematic diagram of a longitudinal section of a substrate processing apparatus provided in embodiment 1 of the present invention, wherein a carrier table is located in a process position for performing a process treatment on the substrate;
FIG. 3 shows a three-dimensional structural view of a lower housing and substrate holding portions in embodiment 1 of the present invention;
FIG. 4 shows a three-dimensional structural view of a lower housing in embodiment 1 of the present invention;
FIG. 5 shows a three-dimensional structural view of a lower housing in embodiment 1 of the present invention, wherein a cover is hidden;
FIG. 6a shows a top view of FIG. 5;
FIG. 6b shows a schematic diagram of another embodiment of a gas flow channel in embodiment 1 of the present invention, wherein the exhaust flow channels are independent of each other;
FIG. 7a shows a schematic diagram of another embodiment of an exhaust portion in embodiment 1 of the present invention, wherein the exhaust portion has two exhaust grooves;
FIG. 7b shows a schematic diagram of another embodiment of an exhaust portion in embodiment 1 of the present invention, wherein the exhaust portion has four exhaust grooves;
FIG. 8 shows a schematic diagram of a longitudinal section of a substrate processing apparatus provided in embodiment 2 of the present invention, wherein a carrier table is located in a process position for performing a process treatment on the substrate;
FIG. 9 shows a three-dimensional structural view of a lower housing and substrate holding portions in embodiment 2 of the present invention; and
FIG. 10 shows an A-A sectional view in FIG. 8.

### PREFERRED EMBODIMENTS OF THE INVENTION

The following illustrates the embodiments of the present invention by means of specific and concrete embodiments, and other advantages and effects of the present invention can be readily understood by those skilled in the art from the contents disclosed in this specification. The present invention may also be implemented or applied in other different and specific embodiments, and the details in this specification may be modified or changed in various ways based on different views and applications without departing from the spirit of the present invention.

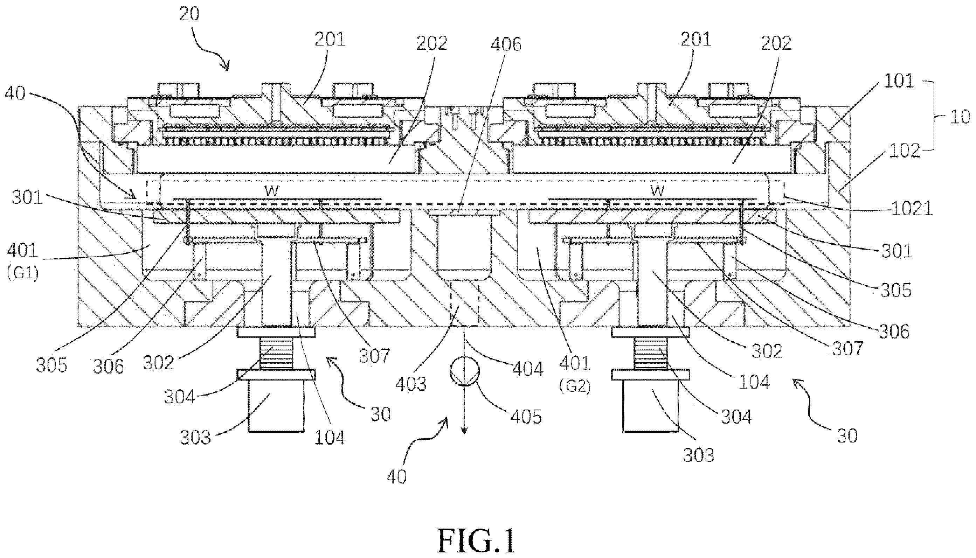

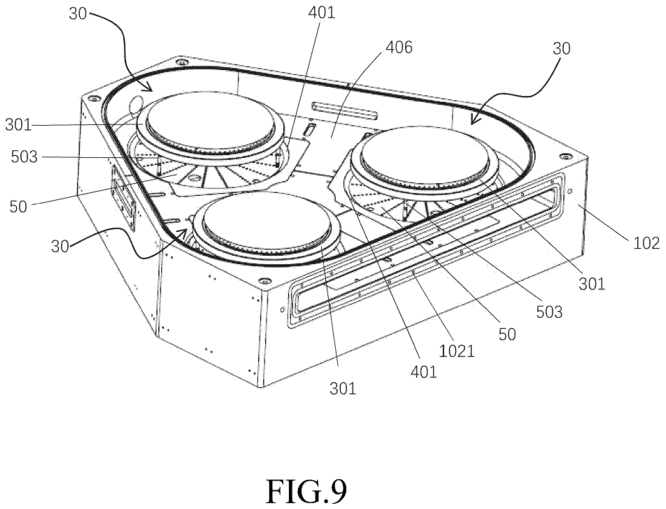

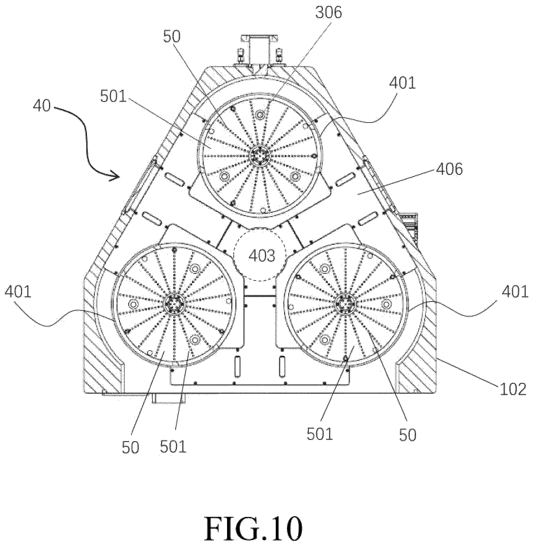

Please refer to FIGS. 1 to 10. It should be noted that the illustrations provided in this embodiment only illustrate the basic concept of the present invention in a schematic manner. Although the illustrations only show the components related to the present invention and are not drawn in accordance with the actual implementation of the number of components, shapes and sizes, the forms, numbers, and proportion of the components with the actual implementation may be an arbitrary change, and the layouts and forms of the components may be more complex.

Below, the embodiments of the present invention are explained while referring to the accompanying drawings. In addition, in this specification and the drawings, elements that have essentially the same functional structures are marked the same drawing labels and omit the repeated explanations.

### First embodiment

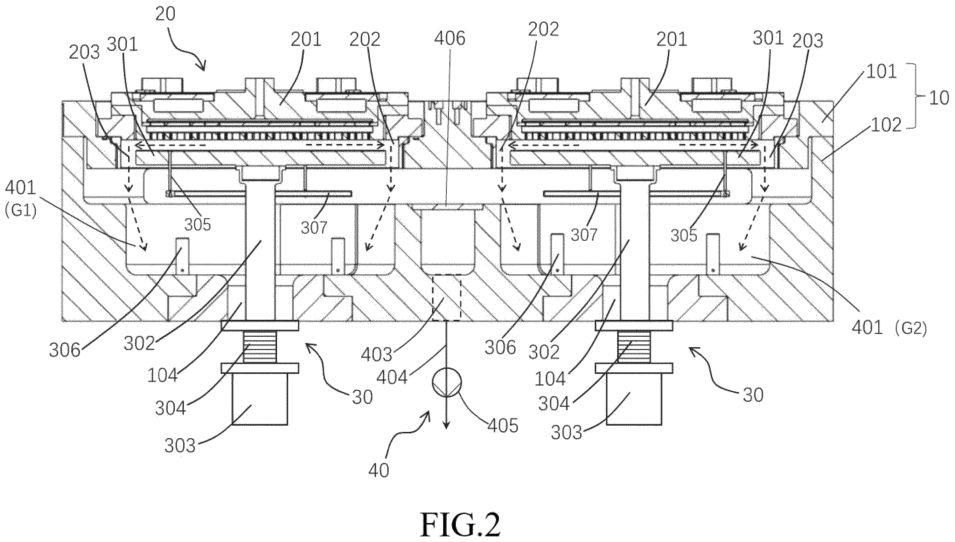

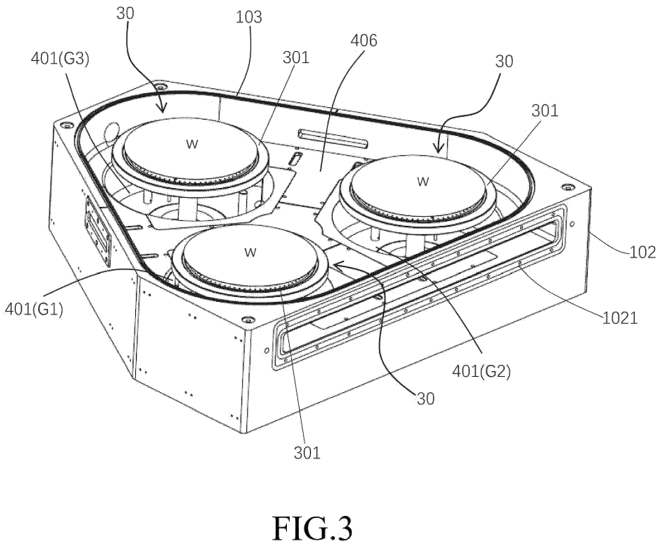

Referring to FIGS. 1 and 2, the substrate processing apparatus comprises a processing chamber 10. The processing chamber 10 is hermetically sealed and can be used to perform processes such as thin film deposition, etching and other processes on the substrate under a vacuum environment. The processing chamber 10 comprises a top cover 101 and a lower housing 102, wherein the top cover 101 serves as the upper portion of the processing chamber 10 and the lower housing 102 serves as the lower portion of the processing chamber 10. As shown in FIG. 3, a seal 103 is disposed between the top cover 101 and the lower housing 102 to make the two portions gas-tight, such as a sealing ring.

The substrate processing apparatus further comprises a gas supply portion 20. As shown in FIGS. 1 and 2, the gas supply portion 20 is configured in an upper portion of the processing chamber 10 for supplying the processing gas into the processing chamber 10. In this embodiment, the gas supply portion 20 is mounted on the top cover 101 of the processing chamber 10. In one embodiment, the gas supply portion 20 comprises a plurality of gas nozzles 201 having a deflector shield 202 on the outer peripheral side, and the deflector shield 202 defines an area that can be used as a processing space for performing a process treatment on a substrate.

The substrate processing apparatus further comprises a plurality of substrate holding portions 30. As shown in FIGS. 1 and 2, a plurality of substrate holding portions 30 are configured below the gas supply portion 20 to hold the substrate w. A plurality of substrate holding portions 30 correspond to a plurality of gas nozzles 201, and the substrate holding portions 30 are disposed relative to the gas nozzles 201. A substrate holding portion 30 and the gas nozzles 201 corresponding to the substrate holding portion 30 form a processing unit, for performing processes such as thin film deposition and etching on a substrate.

The substrate holding portions 30 comprise a carrier table 301, a support shaft 302 and a liftable mechanism 303. The carrier table 301 is used to hold a substrate w. The carrier table 301 may be equipped with a heating structure for heating the substrate. The heating structure may be, for example, an electric heating plate embedded in the carrier table 301. The upper end of the support shaft 302 is fixed to the carrier table 301, and a mounting hole 104 is provided at the bottom of the processing chamber 10, specifically, the mounting hole 104 is a penetration hole at the bottom center of the exhaust grooves 401. And the lower end of the support shaft 302 passes through the mounting hole 104 and is connected to a liftable mechanism 303. The liftable mechanism 303 drives the carrier table 301 up and down by means of the support shaft 302. In order to seal the mounting hole 104, a sealing structure 304 such as a corrugated sealing tube or a magnetic fluid may be provided between the liftable mechanism 303 and the processing chamber 10. In this embodiment, the liftable mechanism 303 drives the carrier table 301 up and down between a transfer position (shown in FIG. 1) for handing over the substrate to an external transfer mechanism (not shown) and a process position (shown in FIG. 2) for performing a process treatment on the substrate held on the carrier 301, wherein the process position is located in the processing space defined by the deflector shield 202.

In this embodiment, the carrier table 301 has a support pin assembly for picking and placing the substrate in conjunction with an external transfer mechanism. As shown in FIGS. 1 and 2, the support pin assembly comprises a plurality of support pins 305 and a plurality of support posts 306. A plurality of support pins 305 are configured in the carrier table 301 in a manner that extends through the carrier table 301, and a plurality of support pins 305 are uniformly distributed around the center axis of the carrier table 301. A plurality of support pins 305 have lower ends that are connected by a connecting ring 307. A plurality of support posts 306 are located below the connecting ring 307 and are mounted at the bottom of the lower housing 102, so as to up and down a plurality of support pins 305 relative to the carrier table 301.

In practical process, when the carrier table 301 is lowered to the transfer position, a plurality of support pins 305 are lifted up by a plurality of support posts 306, at which time the upper ends of a plurality of support pins 305 protrude from the upper surface of the carrier table 301. As illustrated in FIG. 1, the external transfer mechanism removes the substrate w supported on the support pins 305 from the processing chamber 10 through the transfer port 1021 (indicated by dashed bars in FIG. 1) provided on the side wall of the lower housing 102, or the substrate w is conveyed into the processing chamber 10 and supported on the support pins 305. It is noted that the transfer port 1021 may be closed or opened by a valve not shown in the picture. In this embodiment, the support posts 306 are stationary sections. When a plurality of support pins 305 rise with the carrier table 301 and disengage from the support posts 306, a plurality of support pins 305 firstly place the substrate on the upper surface of the carrier table 301, and then continue to rise with the carrier table 301 to the process position in a manner that the support pins 305 are suspended from the carrier table 301, as illustrated in FIG. 2. In other embodiments, the support posts 306 may be movable sections, such as cylinders with liftable functions, to drive the support pins 305 up and down relative to the carrier table 301.

The dashed arrows in FIG. 2 illustrate the flow path of the processing gas in the processing chamber when the substrate is performed the process treatment. As shown in FIG. 2, when the carrier table 301 is raised to the process position, an exhaust annular gap 203 is formed between the inner peripheral surface of the deflector shield 202 and the outer peripheral surface of the carrier table 301, and the processing gas supplied by the gas nozzles 201 is discharged downwardly from the outer peripheral surface of the carrier table 301 through the exhaust annular gap 203. It is to be noted that by designing a suitable size of the exhaust annular gap 203 and selecting a suitable height for the process position, the gas nozzles 201 are capable of uniformly supplying gas on the surface of the substrate when the substrate is in the process position.

However, the flow of processing gas on the surface of substrate is not only related to the gas supply, but also to the gas emission. For example, in the prior art, the area below the carrier table is a completely connected exhaust area, in the center of which an exhaust port is arranged for exhausting the gas from the entire exhaust area and the processing chamber. A number of carrier tables are arranged around the exhaust port. However, in such an exhaust structure, the gas flows directly downwards from the surface of the substrate towards the exhaust port. The gas exhaust rate of the gas is the fastest near the exhaust port and the slowest away from the exhaust port. Accordingly, the gas exhaust rate on the substrate near the exhaust port can be significantly greater than the gas exhaust rate away from the exhaust port, causing the gas on the substrate deflect to one side of the substrate, further affecting the in-surface uniformity of the substrate.

For the above reasons, in the present application, the substrate processing apparatus further comprises an exhaust portion 40 for realizing uniform exhaust, improving the in-surface uniformity of the substrates and the consistency between different substrates. As shown in FIGS. 1 to 6a, the exhaust portion 40 is configured in the lower housing 102. The exhaust portion 40 is disposed opposite the gas supply portion 20 and located below the gas supply portion 20, for applying a suction force to the processing gas. In this embodiment, the flow direction of the processing gas is as shown by the arrow in FIG 2. The processing gas is supplied from the gas nozzles 201 to the corresponding surface of the substrate, and then spreads uniformly along the surface of the substrate to the edges of the substrate. Then, the processing gas is discharged downwardly along the exhaust annular gap 203 on the outside of the carrier table 301, and finally discharged out of the processing chamber 10 by the exhaust portion 40.

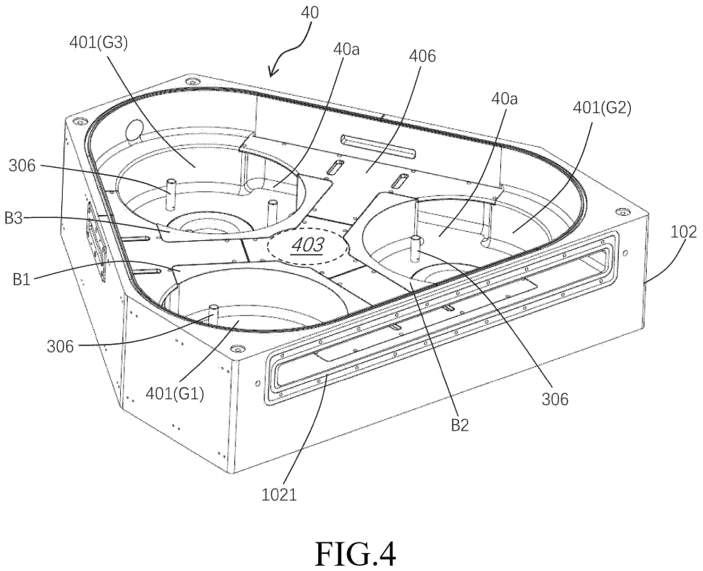

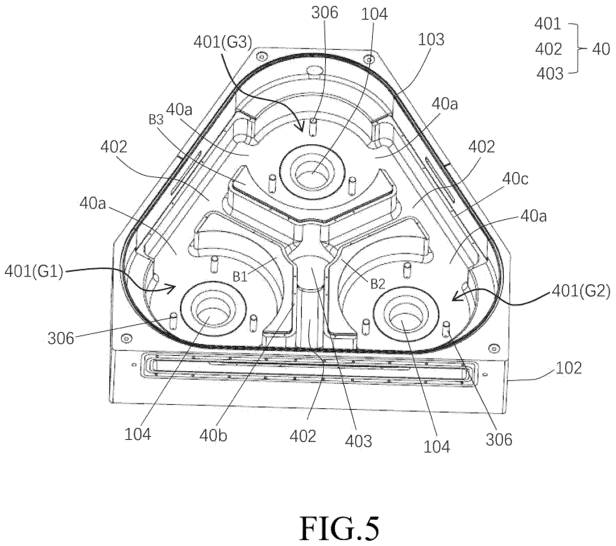

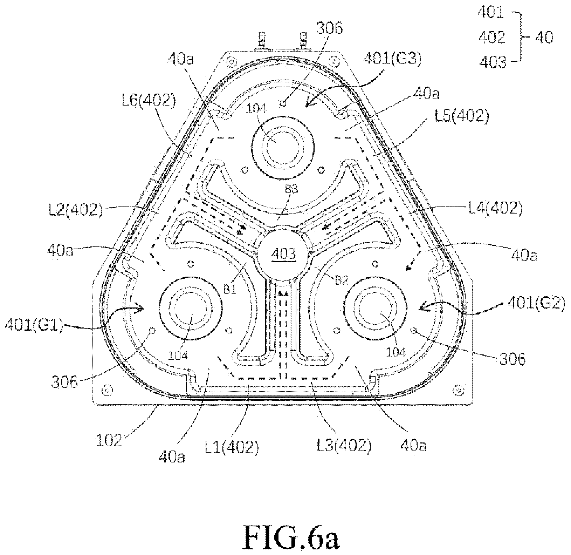

FIG. 3 shows a three-dimensional structural view of the lower housing 102 and the substrate holding portions 30, wherein the top cover 101 and the gas supply portion 20 are hidden and the carrier table 301 is in a raised state. FIGS. 4 and 5 show a structural view of the lower housing 102, wherein the cover 406 is hidden in FIG. 5 for the purpose of illustrating the exhaust flow channels 402 below the cover 406. FIG 6a illustrates a top view of FIG 5. The structure of the exhaust portion 40 is described below in conjunction with FIGS 3 to 6a.

As shown in FIGS. 3 to 6a, the exhaust portion 40 comprises a plurality of exhaust grooves 401, a plurality of exhaust flow channels 402 and a shared main exhaust port 403. Each exhaust groove 401 is configured with a substrate holding portion 30, and each exhaust groove 401 is configured with two exhaust flow channels 402, to connect the exhaust grooves 401 to the main exhaust port 403. The main exhaust port 403 is located at the geometric center of a plurality of substrate holding portions 30, and each exhaust flow channel 402 has the same exhaust volume. In this embodiment, as shown in FIGS. 1 and 2, a plurality of exhaust grooves 401 correspond to a plurality of gas nozzles 201 with the aforementioned, and each gas nozzle 201 is disposed opposite a carrier table 301 of the substrate holding portions 30, for supplying the processing gas to the substrate held on the carrier table 301. A main exhaust port 403 is connected to an exhaust pump 405 through an exhaust line 404, so as to uniformly exhaust gas from a plurality of exhaust grooves 401 and the entire processing chamber 10.

Referring again to FIGS. 3 to 6a, each exhaust groove 401 is roughly cylindrical in shape, forming a circular gas flow space below the carrier table 301, providing a large buffer space for the outflow of gas, and avoiding a large amount of gas from impinging on the various walls of the processing chamber 10, which may cause disturbed flow. Specifically, when the substrate is performed a process treatment, the carrier table 301 holds the substrate in the process position, and the processing gas supplied by the gas nozzles 201 is discharged downwardly along the outer peripheral surface of the carrier table 301 and is sucked into the corresponding exhaust grooves 401. Then, the processing gas flows from the corresponding exhaust flow channels 402 of the exhaust grooves 401 towards the main exhaust port 403.

As shown in FIG. 6a, each exhaust groove 401 is configured with two exhaust flow channels 402 to connect the exhaust grooves 401 to the main exhaust port 403. The two exhaust flow channels 402 are symmetrical about the line connecting the center of the exhaust grooves 401 and the center of the main exhaust port 403. Thus, for a single exhaust groove 401, the two exhaust flow channels 402 of the exhaust grooves 401 are distributed on both sides of the main exhaust port 403, and part of the body of the exhaust grooves 401 (i.e., the later described partitions Bl to B3) will act as a barrier between the exhaust grooves 401 and the main exhaust port 403 to block the gas flow. At the same time, the gas in the exhaust groove 401 is uniformly divided into two symmetrical flow paths to the main exhaust port 403, so that the processing gas that does not participate in the reaction on the surface of the substrate can be released quickly and symmetrically, avoiding the processing gas from staying on the surface of the substrate for too long time and causing the formation of particle defects on the surface of substrate. At the same time, the uniformity of the gas exhaust of the substrate in the entire circumferential direction can be effectively improved, and thus improve the in-surface uniformity of the thin film deposition or etching of the substrate.

Each exhaust groove 401 is provided with two extraction ports 40a on the groove body, as shown in FIG 6a, each extraction port 40a is connected to an inlet end of one exhaust flow channel 402, and an outlet end of each exhaust flow channel 402 is connected to a main exhaust port 403. The two extraction ports 40a of each exhaust groove 401 may be designed to be symmetrical about the center of the exhaust grooves 401. For example, in this embodiment, the two extraction ports 40a on the cylinder-shaped exhaust grooves 401 are located on both sides of the diameter of the exhaust grooves 401. In other embodiments, for example, the two extraction ports 40a on the square-shaped exhaust grooves 401 may be located at two ends of the diagonal of the exhaust grooves 401.

In order to achieve uniform gas exhaust of multiple substrates and a good inter-slice uniformity, it is also necessary to ensure that the multiple exhaust grooves 401 are consistent with each other in terms of exhaust volume and exhaust uniformity. Based on this situation, in the present application, the exhaust volume of each exhaust flow channel 402 is the same, that is, the exhaust volume of the main exhaust port 403 is uniformly distributed among the multiple exhaust flow channels 402. In one specific embodiment, each exhaust groove 401 and the two exhaust flow channels 402 configured in the exhaust groove 401 form one exhaust unit, and a plurality of exhaust units are uniformly distributed around a circumference centered on the main exhaust port 403. Hence, a plurality of exhaust units are symmetrical to each other, so that the exhaust paths of a plurality of exhaust flow channels 402 are the same, and thus the exhaust volume of each exhaust flow channel 402 is the same, which is used to realize uniform gas exhaust of multiple substrates. In the existing exhaust structure, the gas generally flows directly downward from the surface of the substrate towards the pump port. In contrast, in this application, by designing the exhaust grooves 401 and the exhaust flow channels 402, the gas flows to the main exhaust port 403 in a direction parallel to the main exhaust port 403, avoiding the disturbed flow at the main exhaust port 403, which is conducive to the uniformity of gas exhaust.

The exhaust portion 40 in this embodiment is described below in FIGS. 4 to 6a, using three exhaust units as examples.

The exhaust portion 40 comprises three exhaust slots G1 to G3 and six exhaust flow passages LI to L6. A main exhaust port 403 is located at the bottom center of the lower housing 102. Three partitions Bl to B3 are arranged around the main exhaust port 403, and a cover 406 is provided above the main exhaust port 403.

A first exhaust slot G1 is formed between the inner peripheral surface of the first partition Bl and the inner peripheral surface of the lower housing 102. A second exhaust slot B2 is formed between the inner peripheral surface of the second partition B2 and the inner peripheral surface of the lower housing 102, and a third exhaust slot G3 is formed between the inner peripheral surface of the third partition B3 and the inner peripheral surface of the lower housing 102.

The upper surfaces of the first partition Bl, the second partition B2 and the third partition B3 have a first step 40b for mounting the cover 406, and the inner peripheral surface of the lower housing 102 has a second step 40c for mounting the cover 406. The first step 40b and the second step 40c are located in the same horizontal plane, and the cover 406 is fixed to the first step 40b and the second step 40c by fasteners such as screws. And the cover 406 is located above the main exhaust port 403. Preferably, the three partitions Bl to B3 and the upper surface of the cover 406 are flush with the lower edge of the transfer port 1021, so that the substrate is easily picked and placed by an external transfer.

The outer peripheral surfaces of three partitions Bl to B3, the inner peripheral surface and the bottom surface of the lower housing 102 and the lower surface of the cover 406 are formed together into a flow space on the outer side of the three exhaust slots G1 to G3. There are six exhaust flow passages L1 to L6 formed in the flow space. FIG. 6a shows a top view of the lower housing 102, and the cover 406 is not shown in FIG. 6a in order to clearly show the exhaust flow channels 402, and the direction of gas flow in each exhaust flow channel 402 is shown by an arrow in FIG. 6a. As shown in FIG. 6a, the first exhaust slot G1 is connected to the main exhaust port 403 through the first exhaust flow passage L1 and the second exhaust flow passage L2, forming the first exhaust unit. Wherein, the first exhaust flow passage L1 and the second exhaust flow passage L2 are symmetrical about a line connecting the center of the first exhaust slot G1 and the center of the main exhaust port 403. The second exhaust slot G2 is connected to the main exhaust port 403 through the third exhaust flow passage L3 and the fourth exhaust flow passage L4, forming the second exhaust unit. Wherein, the third exhaust flow passage L3 and the fourth exhaust flow passage L4 are symmetrical about a line connecting the center of the second exhaust slot G2 and the center of the main exhaust port 403. The third exhaust slot G3 is connected to the main exhaust port 403 through the fifth flow passage L5 and the sixth flow passage L6, forming the third exhaust unit. Wherein, the fifth exhaust flow passage L5 and the sixth exhaust flow passage L6 are symmetrical about a line connecting the center of the third exhaust slot G3 and the center of the main exhaust port 403. The three exhaust units are uniformly distributed around a circumference centered on the main exhaust port 403. In other words, the three exhaust units are symmetrical to each other and distributed in a circular array with the center of the main exhaust port 403, so that the exhaust paths of the six exhaust flow channels 402 are the same, and thus each exhaust flow channel 402 acts on the same amount of gas exhaust from the corresponding exhaust grooves 401.

The following is an example of the first exhaust unit to illustrate the uniformity of gas exhaust of a single exhaust unit. When the substrate is raised to the process position with the carrier table 301, as shown in FIG. 2, a narrow processing space is formed between the gas nozzles 201 and the substrate. And an exhaust annular gap 203 is formed between the outer peripheral surface of the carrier table 301 and the inner peripheral surface of the deflector shield 202. The gas nozzles 201 supply the processing gas to the substrate, and within the constraints of the exhaust annular gap 203, the processing gas is discharged in the entire circumferential direction of the substrate through the exhaust annular gap 203 downwardly towards the first exhaust slot G1 located below the gas nozzles 201. As shown in FIG. 6a, due to a certain blocking effect of the first partition Bl on the gas flow to the main exhaust port 403, the processing gas entering the first exhaust slot G1 is dispersed into two paths, and flows into the main exhaust port 403 from both sides of the main exhaust port 403 through the first exhaust flow passage LI and the second exhaust flow passage L2. The above method is help to equalize the suction force of the first exhaust slot G1 at different positions in the circumferential direction of the substrate, realizing the uniformity of gas exhaust, and thus making the exhaust speed of the processing gas at different locations in the circumferential direction of the substrate basically the same, thereby effectively improving the distribution of gas flow on the surface of the substrate. The uniformity of gas exhaust of the second exhaust unit and the third exhaust unit is the same as the first exhaust unit, and will not be repeated.

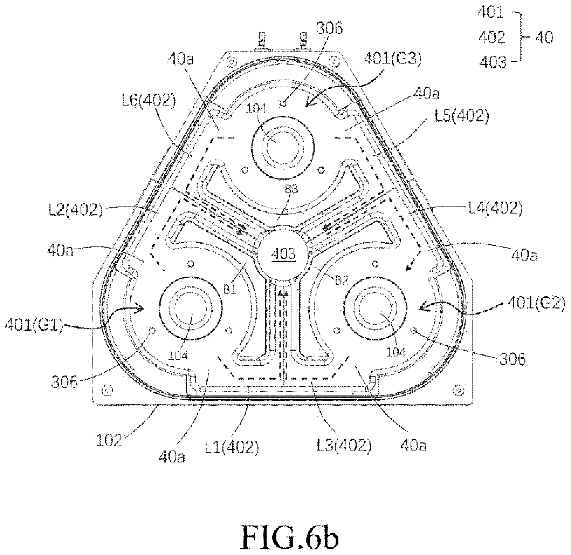

In this embodiment, the adjacent exhaust flow channels 402 of the different exhaust grooves 401 may at least partially overlap, so that the gas from the different exhaust grooves 401 converge to flow in one path towards the main exhaust port 403. In FIG. 6a, the gas flowing out of the three exhaust grooves 401 through the two corresponding exhaust flow channels 402 converge into three paths and flow in three directions towards the main exhaust port 403, which can serve to smooth and buffer the gas flow. Specifically, as shown in FIG. 6a, the gas out of the first exhaust slot G1 through the first exhaust flow passage LI and the gas out of the second exhaust slot G2 through the third exhaust flow passage L3 converge into one path and flow in the first direction towards the main exhaust port 403. The gas out of the second exhaust slot G2 through the fourth exhaust flow passage L4 and the gas out of the third exhaust slot G3 through the fifth exhaust flow passage L5 converge into one path and flow in the second direction towards the main exhaust port 403. The gas out of the third exhaust slot G3 through the sixth exhaust flow passage L6 and the gas out of the first exhaust slot G1 through the second exhaust flow passage L2 converge into one path and flow in the third direction towards the main exhaust port 403. It should be noted that in other examples, as shown in FIG. 6b, a plurality of exhaust flow passages LI to L6 may be independent of each other, and the intersections of gas flow are non-existent.

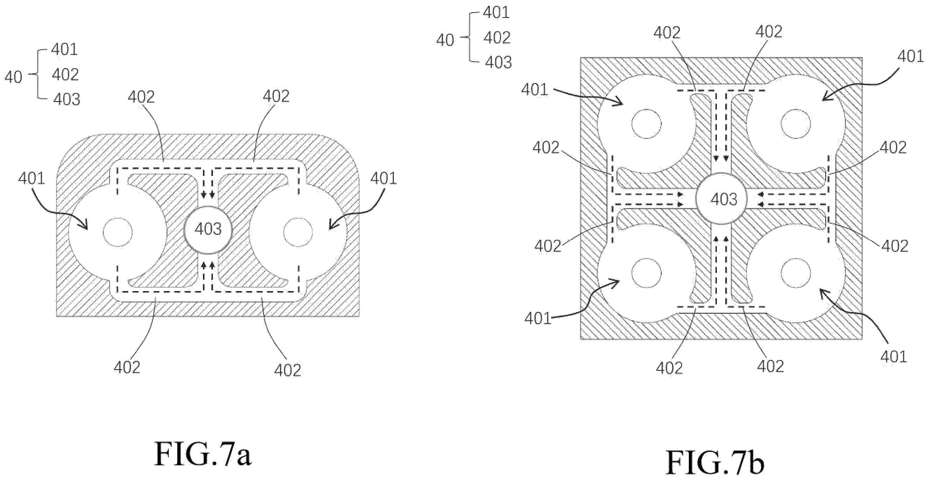

It should be noted that FIGS. 3 to 6b are only examples and are not intended to limit the numbers and shapes of the exhaust grooves 401 provided in the exhaust portion 40. For example, in another example of the exhaust portion 40 illustrated in FIG. 7a, the exhaust portion 40 comprises two exhaust grooves 401 and four exhaust flow channels 402, and each exhaust groove 401 has two exhaust flow channels 402. For example, in another example of the exhaust portion 40 illustrated in FIG. 7b, the exhaust portion 40 comprises four exhaust grooves 401 and eight exhaust flow channels 402, and each exhaust groove 401 has two exhaust flow channels 402.

### Second embodiment

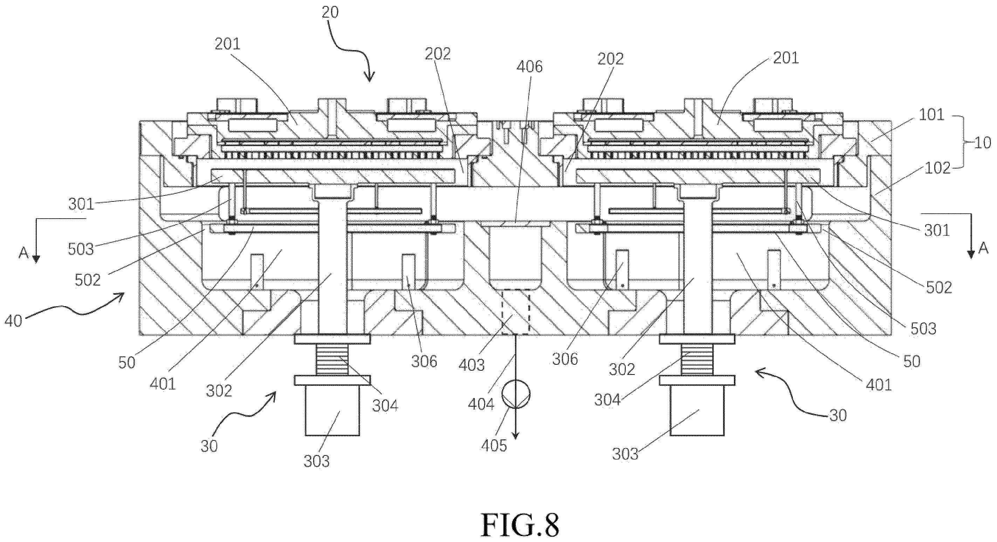

Referring to FIGS. 8 to 10, the present embodiment provides a substrate processing apparatus, as compared to embodiment 1, the present embodiment is distinguished in that the substrate holding apparatus further comprises rectifier boards 50, and each rectifier board 50 is fixed at an interval by a connecting rod 503 below each carrier table 301. The rectifier board 50 is provided with a plurality of gas inlet holes 501. When the carrier table 301 is raised to the process position, the rectifier board 50 is raised to the groove opening position of the exhaust grooves 401. An inlet annular gap 502 is formed between the outer peripheral surface of the rectifier board 50 and the inner peripheral surface of the exhaust grooves 401, so that the processing gas passes through the inlet annular gap 502 and a plurality of gas inlet holes 501 enter into the exhaust grooves 40l.

The above embodiments are only illustrative of the principles and efficacies of the present invention, and are not intended to limit the present invention. Any person skilled in the art may modify or change the above embodiments without violating the spirit and scope of the present invention. Therefore, all equivalent modifications or changes made by people having ordinary knowledge in the art without departing from the spirit and technical ideas disclosed in the present invention shall be covered by the claims of the present invention.

## Claims

1. A substrate processing apparatus, comprising:
a processing chamber;
a gas supply portion, configured in an upper portion of the processing chamber, for supplying processing gas into the processing chamber;
a plurality of substrate holding portions, configured in the processing chamber and located below the gas supply portion, for holding substrates;
an exhaust portion, configured in a lower portion of the processing chamber, for exhausting gas from the processing chamber, the exhaust portion comprising a plurality of exhaust grooves, a plurality of exhaust flow channels and a shared main exhaust port, each exhaust groove configured with a substrate holding portion and two exhaust flow channels, for connecting the exhaust groove to the main exhaust port;
wherein, the main exhaust port is located at a geometric center of the plurality of substrate holding portions, and the plurality of exhaust flow channels have the same exhaust volume.

2. The substrate processing apparatus according to claim 1, wherein two exhaust flow channels configured for each exhaust groove are symmetrical about a line connecting the center of exhaust groove and the center of main exhaust port, each exhaust groove and the two exhaust flow channels configured for each exhaust groove form an exhaust unit, and a plurality of exhaust units are uniformly distributed around a circumference centered on the main exhaust port.

3. The substrate processing apparatus according to claim 1, wherein the plurality of exhaust flow channels are independent of each other.

4. The substrate processing apparatus according to claim 1, wherein adjacent exhaust flow channels of different exhaust grooves at least partially overlap, so that the gas in the different exhaust grooves converge to flow all the way to the main exhaust port.

5. The substrate processing apparatus according to claim 1, wherein each substrate holding portion comprises:
a carrier table, for holding the substrate;
a support shaft, the upper end of the support shaft being secured to the carrier table;
a liftable mechanism, connected to the lower end of the support shaft, for driving the carrier table up and down between a process position for performing a process treatment on the substrate and a transfer position for handing over the substrate to an external transfer mechanism.

6. The substrate processing apparatus according to claim 5, further comprising rectifier boards, with one of the rectifier boards fixed at an interval below each carrier table, and when the carrier table is located in the process position, the rectifier board rises with the carrier table to the groove opening position of the corresponding exhaust groove, and an inlet annular gap is formed between the outer peripheral surface of the rectifier board and the inner peripheral surface of the exhaust groove.

7. The substrate processing apparatus according to claim 6, wherein the rectifier boards are provided with a plurality of gas inlet holes.

8. The substrate processing apparatus according to claim 5, wherein the gas supply portion comprises a plurality of gas nozzles corresponding to the plurality of exhaust grooves, each gas nozzle is disposed opposite to one carrier table for supplying the processing gas to a substrate holding on the carrier table, each gas nozzle has a deflector shield on the outer peripheral side, so that when the carrier table is in a process position, an exhaust annular gap is formed between the inner peripheral surface of the deflector shield and the outer peripheral surface of the carrier table, to allow the processing gas supplied by the gas nozzles to be discharged downwardly along the exhaust annular gap towards the corresponding exhaust groove.
